Europäisches Patentamt

European Patent Office

Office européen des brevets

(11) Publication number: **0 107 202**
**B1**

(12) **EUROPEAN PATENT SPECIFICATION**

(45) Date of publication of patent specification: **06.08.86**

(21) Application number: **83110614.1**

(22) Date of filing: **24.10.83**

(51) Int. Cl.⁴: **H 01 L 31/02,** H 01 L 31/18

(54) **Opto-electronic device and process for its fabrication.**

(30) Priority: **25.10.82 IT 6823682**

(43) Date of publication of application:
**02.05.84 Bulletin 84/18**

(45) Publication of the grant of the patent:
**06.08.86 Bulletin 86/32**

(84) Designated Contracting States:
**DE FR GB NL**

(56) References cited:
**EP-A-0 062 367**
**DE-A-2 845 612**
**US-A-3 426 253**

(73) Proprietor: **CSELT Centro Studi e Laboratori Telecomunicazioni S.p.A.**
**Via Guglielmo Reiss Romoli, 274**
**I-10148 Turin (IT)**

(72) Inventor: **de Padova, Matteo**
**Via Quasimodo, 1**
**Vimodrone (Milano) (IT)**
Inventor: **Stano, Giuseppe**
**Via Gazzera, 12**
**Cirié (TO) (IT)**

(74) Representative: **Riederer Freiherr von Paar zu Schönau, Anton et al**
**Freyung 615 Postfach 2664**
**D-8300 Landshut (DE)**

## Description

The present invention relates to solid-state devices for telecommunications systems operating at high transmission rate and in particular it refers to an opto-electronic device and to a process for its fabrication.

It is known that telecommunications systems using optical fibres as physical carriers require opto-electronic devices, i.e. sources and detectors, operating at high-speed and with high efficiency in order to allow for the contemporaneous transmission of a great quantity of channels and allow the use of long trunks of optical fibres without line repeaters (book: Optical Fibre Communication, McGraw-Hill Book Company 1981, chapter 2: Photodetectors, by P. L. Carni).

To reach a high transmission rate it is necessary to reduce as much as possible the physical dimensions of the photodetecting devices, so as to reduce both the electrical capacity and the reverse current, named "dark" current, which causes noise.

Otherwise, by reducing the size of the surface which receives the light radiation, also coupling efficiency is reduced.

Hence a suitable compromise between these opposite requirements is to be realized taking also into account that a portion of the active region is covered with a metallic layer, necessary to establish the connection with the terminal: which implies a further capacity increase. Otherwise, the size of said metallic layer cannot be reduced too much due to manufacturing difficulties. This problem is particularly important when the device is to be used at rather high transmission rate.

A further problem is encountered during the device assembly, when a suitably-shaped end of the wire connected to the device terminal is soldered by pressure to the metallic layer. This operation causes strains and deformations inside the device structure, which may result degraded in its characteristics and often unusable.

For a mesa-structure infra-red radiation detector, comprising a semiconductor body having a junction formed by ion-etching, it is known (EP—A—0 062 367) to define the area of the junction by removing a peripheral part of the one-conductivity-type region over its whole thickness and to deposit and insulating layer on the upper surface, this layer being provided with openings though which metal layer electrodes contacting the semiconductor regions penetrate.

For a semiconductor device such as a diode or a transistor, it is known (US—A—3 426 253) to etch a V-shaped notch into the semiconductor body so as to remove the lateral boundary of the junction, the upper surface with the exception of some contact zones but including the notch being covered by an insulating film which is covered by a metal film.

By such structures, however, the above problems, particularly the capacity problem, can not be solved optimally.

The disadvantages above are overcome by the present invention which allows the manufacturing of opto-electronic devices with low electrical capacity and low reverse current, maximizing the optical coupling with the fibre and the output during the fabrication.

The present invention provides a solid-state opto-electronic device for detecting a light radiation incident on its active region in which said region is insulated from the surrounding semiconductor by a cavity, filled with resin with high resistivity and thermal expansion coefficient similar to that of the semiconductor, said resin spreading also on the surface of the device through which the light radiation penetrates, with the exception of the active region, whose surface layer is made to contact a metallic layer deposited on said resin and having a bonding pad area located away from the active region, for the soldering of a connection wire.

The foregoing and other characteristics of the present invention will be made clearer by the following description of a preferred embodiment thereof, given by way of example and not in a limiting sense, and by the annexed drawing in which:

Fig. 1 represents a transversal sectional view of a photodetector manufactured according to the invention;

Fig. 2 represents the view from top of the photodetector of Fig. 1.

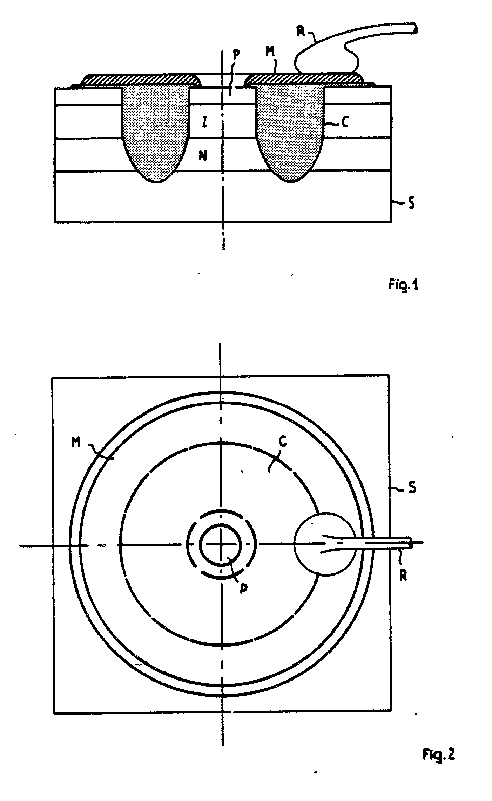

In the example depicted in Fig. 1 there is represented the section of a PIN photodetector, i.e. consisting of a top layer P of $p^+$ semiconductor, of an intrinsic semiconductor layer I and of a bottom layer N of $n^+$ semiconductor. S denotes the substrates of InP on which the layers above have grown by molecular beam epitaxy (MBE).

The device active-region is bound by an annular cavity C filled with high-resistivity resin. Said resin spreads also on the top surface of the device with the exception of the only central active region through which the light radiation penetrates. The resin is also to present a thermal expansion coefficient equal to that of the semiconductor.

A metallic layer M is deposited on the resin. M allows the electrical contact of layer P of the semiconductor with the connection wire R, soldered by pressure to layer M.

The latter is better seen in Fig. 2, which shows the view from top of PIN photodetector.

Metallic layer M can assume other shapes, provided the contact is ensured with layer P and a pad is provided for the contact with connection wire R. This pad is to be placed on the side of the active region, so that the pressure exerted during the soldering cannot damage the semiconductor layers designed to detect the light radiation.

The metallic layer placed in correspondence with the active region does not necessarily have an annulus shape, as shown in Fig. 2, but it can also have a circular sector shape.

The process for making the just-described device comprises, in addition to the usual operations for manufacturing a PIN diode, composed of the necessary series of semiconductor layers, the following operations:

— manufacturing of an annular cavity by chemical etching;
— filling of the cavity and covering of the device surface with insulating resin;
— removal of a circular resin area in correspondence with the active region;
— deposition of a gold or aluminium layer on the resin;
— removal of a circular metallic area, smaller than the preceding one, in correspondence with the active region;
— soldering of the connection wire to the metallic layer by pressure.

In the case in which a layer having the shape of a circular sector, instead of an annulus, is required, the corresponding removal, performed by photochemical procedures, will involve a wider zone.

**Claims**

1. A solid-state opto-electronic device for detecting a light radiation incident on its active region, characterized in that said region is insulated from the surrounding semiconductor by a cavity (C), filled with resin with high resistivity and thermal expansion coefficient similar to that of the semiconductor, said resin spreading also on the surface of the device through which the light radiation penetrates, with the exception of the active region, whose surface layer (P) is made to contact a metallic layer (M) deposited on said resin and having a bonding pad area located away from the active region, for the soldering of a connection wire (R).

2. Process for fabricating the device according to claim 1, wherein in a multilayer semiconductor substrate the following operations are effected:

— manufacturing of a cavity for bounding the active region of the device;
— filling of the cavity and covering the device surface with insulating resin;
— removal of a resin area in correspondence with the active region;
— deposition of a metallic layer on the resin;
— removal of an area of said metallic layer, smaller than the above resin area in correspondence with the active region;
— soldering of a connection wire to said metallic layer.

**Patentansprüche**

1. Opto-elektronisches Festkörper-Bauelement zum Festellen einer auf seinen aktiven Bereich auftreffenden Lichtstrahlung, dadurch gekennzeichnet, daß dieser Bereich gegen den umgebenden Halbleiter durch eine Vertiefung (C) isoliert ist, die mit Harz hohen spezifischen Widerstands und eines thermischen Ausdehnungskoeffizienten etwa gleich dem des Halbleiters gefüllt ist, wobei das Harz auch über die Oberfläche des Bauelements, durch die die Lichtstrahlung hindurchtritt, ausgebreitet ist mit Ausnahmen des aktiven Bereichs, dessen Oberflächenschicht (P) mit einer auf dem Harz angebrachten Metallschicht (M) kontaktiert ist, die mit einem mit Abstand vom aktiven Bereich liegenden Anschlußteil für das Anlöten eines Anschlußdrahts (R) versehen ist.

2. Verfahren zum Herstellen des Bauelements nach Anspruch 1, bei dem man in einem mehrschichtigem Halbleitersubstrat die folgenden Operationen durchführt:

— man stellt eine den aktiven Bereich des Bauelements begrenzende Vertiefung her;
— man füllt die Vertiefung mit isolierendem Harz und bedeckt auch die Oberfläche des Bauelements mit dem Harz;
— man entfernt das Harz in einer Fläche entsprechend dem aktiven Bereich;
— man bringt eine Metallschicht auf das Harz auf;
— man entfernt die Metallschicht in einer Fläche, die kleiner ist als die dem aktiven Bereich entsprechende genannte Fläche im Harz;
— man lötet einen Anschlußdraht an die Metallschicht.

**Revendications**

1. Dispositif opto-électronique à l'état solide, apte à détecter une radiation lumineuse incidente sur une région active, caractérisé en ce que ladite région est isolée du semi-conducteur qui l'entoure à l'aide d'une tranchée (C), remplie de résine à haute résistivité et avec un coefficient de dilatation thermique similaire à celui du semi-conducteur, ladite résine s'étendant de même sur la surface du dispositif, à travers laquelle la radiation lumineuse pénètre, à l'exception de la région active, dont la couche superficielle (P) est placée en contact avec une couche métallique (M), déposée sur ladite résine et ayant une surface de raccordement, placée loin de la région active, pour la soudure d'un fil de connexion (R).

2. Procédé pour la fabrication du dispositif de la revendication 1, où dans un substrat du semi-conducteur ayant les diverses couches, l'on effectue les opérations suivantes:

— réalisation d'une tranchée apte à délimiter la région active du dispositif;
— remplissage de la tranchée et couverture de la surface du dispositif à l'aide de résine isolante;

— enlèvement d'une partie de résine en correspondance avec la région active;
— déposition d'une couche métallique sur la résine;
— enlèvement d'une partie de la couche métallique, plus petite que ladite partie de résine, en correspondance avec la région active;
— soudure d'un fil de connexion à ladite couche métallique.

Fig. 1

Fig. 2

1